# EUROPEAN PATENT SPECIFICATION

(11) **EP 2 901 255 B1**
(45) Date of publication and mention of the grant of the patent: **25.10.2017**
(21) Application number: 13813515.7
(22) Date of filing: 03.07.2013
(51) Int. Cl.: G06F 3/044, H03K 17/96, G06F 3/041

(54) **PRESSURE SENSING DISPLAY DEVICE**
DRUCKMESSUNGSANZEIGEVORRICHTUNG
DISPOSITIF D'AFFICHAGE SENSIBLE À LA PRESSION

(30) Priority: 05.07.2012 US 201261668439 P
(43) Date of publication of application: 05.08.2015
(60) Divisional application: 17185087.8
(73) Proprietor: Cambridge Touch Technologies, Ltd., Cambridge CB3 0DL (GB)
(72) Inventor: NATHAN, Arokia, Cambridge Cambridgeshire CB3 0DL (GB); LAI, Jackson Chi Sun, Mississauga, Ontario L5W 1W4 (CA); CHA, Suk-Bae, Tokyo 106-0047 (JP); CHURCH, Corbin, Westmont, Québec H3Y 2S8 (CA)
(74) Representative: Piotrowicz, Pawel Jan Andrzej
(86) International application number: PCT/CA2013/000613
(87) International publication number: WO 2014/005218

(56) References cited:
- WO-A1-2011/156447
- US-A- 4 516 112
- US-A- 5 942 733
- US-A1- 2007 262 964
- US-A1- 2009 254 869
- US-A1- 2010 309 164
- US-A1- 2011 096 025
- CANDÈS, EJ ET AL.: 'An Introduction To Compressive Sampling.' IEEE SIGNAL PROCESSING MAGAZINE. March 2008, pages 21 - 30, XP011225660 Retrieved from the Internet: <URL:http: //ieeexplore. ieee. org/stamp/stamp,j sp?tp=&arnumber=4472240&isnu mber=4472102> [retrieved on 2013-08-22]

## Description

### Field

The described embodiments relate to touch sensing digital displays and, in particular, to force or pressure sensing in touch sensing displays.

### Background

Touch panel displays are widely used in consumer electronics, such as smartphones and computing tablets, among other devices. Broadly speaking, there are two types of touch panel technologies currently used in consumer electronics: projected capacitance and resistive. Both types of touch panels typically can only sense the location and time of a touch event on the touch panel (e.g., from a finger or stylus). The location of a touch event is typically recorded only in two dimensions (e.g., x-y coordinates). Conventional touch panels are unable to sense in a third dimension to determine the magnitude of a touch force (e.g., a z-coordinate). Prior attempts at three-dimensional sensing have typically focused on the inclusion of a sensitive analog element. Conventionally, the inclusion of an analog element in what is otherwise a digital system has been costly, bulky and non-trivial.

US 2011/096025 A1 describes methods, systems, and apparatus relating to touch sensors that are configured to measure input applied to the sensor from a user. Some implementations involve the measurement of changes in capacitance between pairs of adjacent patterned electrodes to detect input at a touch sensor.

US 4,516,112 A describes a transparent touch switching system for direct overlay on a display screen to enable operator input by touching the screen. A piezoelectric polymer film is supported above the screen for selective localized depression towards the screen. The film has transparent flexible conductive coatings on opposite sides thereof for voltage generation in response to depression of the film.

US 5,942,733 A describes a capacitive touch pad which includes a rigid substrate having first and second opposing faces, an X-trace layer having a plurality of first parallel conductive traces running in a first direction and lying in a plane parallel to said first face of the substrate and disposed on the first face of the substrate, a Y-trace layer having a plurality of second parallel sensing conductive traces running in a second direction orthogonal to the first direction, the second parallel sensing conductive traces lying in a plane parallel to the second face of the substrate and disposed on said second face of said substrate, a layer of compliant material disposed on the substrate, a layer of conducting material disposed on an upper surface of the layer of compliant material, and a protective layer disposed on an upper surface of the layer of conducting material.

WO 2011/156447 A1 describes a touch screen display sensor that includes a transparent touch-sensing element disposed upon the surface of a transparent substrate and a force-sensing element disposed within the transparent touch-sensing element. The force-sensing element includes two sets of bands of micromesh and can include a pressure-responsive material between the bands of micromesh. The bands of micromesh include traces of a metallic conductor. The sets of bands of micromesh are spaced apart and occupy substantially parallel planes.

### Summary

In a first broad aspect, there is provided a projected capacitance touchscreen device comprising a pressure sensing assembly, the pressure sensing assembly comprising: a detection line, a biasing layer comprising an unpatterned layer; a sensing electrode layer; a piezoelectric material layer provided between the biasing layer and the sensing electrode layer, wherein the piezoelectric material layer acts as a dielectric, an integrator having an integrator input coupled to the sensing electrode layer and an integrator output for providing an integrated output, a first switch configured, in response to receiving a reset input, to provide a reset voltage to the sensing electrode layer and to reset the integrator output to a known condition, and a second switch having a switch input coupled to the integrator output and a switch output coupled to the detection line, such that the integrated output can be coupled to the detection line when the second switch is switched on, and such that the sensing electrode layer is not required to provide an output voltage concurrently with the second switch being in an on state.

The biasing layer may comprise a substantially uniform layer.

The biasing layer may be formed of an optically transparent conductive material.

The sensing electrode layer may comprise a plurality of conductive traces, and each trace may comprise one or more sensing pads.

The sensing pad may be formed of an optically transparent conductive material.

The sensing or driving pads may be shaped to maximize fringing fields and a change in capacitance between the sensing electrode layer and the driving electrode layer in response to stimulus. The sensing or driving pads may have a polygonal shape.

Each conductive trace of the sensing electrode layer may terminate in one sensing pad.

The conductive trace may further comprise an external portion at a periphery of the device, wherein the external portion is formed of an optically opaque conductive material.

Each conductive trace of the sensing electrode layer may comprise a plurality of sensing pads.

The device may further comprise a detection circuit operatively connected to the plurality of conductive traces of the sensing layer. The detection circuit may be selectively operable in a first mode and a second mode, wherein in the first mode the detection circuit is configured to detect a change in capacitance at one or more of the conductive traces of the sensing layer, and wherein in the second mode the detection circuit is configured to detect a change in electric current at one or more of the conductive traces of the sensing layer.

The device may further comprise a processor, wherein the processor is configured to interpret pressure data from the one or more sensing pads as an image map. The pressure data may be interpreted using correlated double sampling, compressive sensing, or both.

The pressure data may comprise a plurality of pressure levels, and each pixel in the image map may have a respective pressure level mapped as a level of grey.

### Brief Description of the Drawings

A preferred embodiment of the present invention will now be described in detail with reference to the drawings, in which:
FIG. 1A is a simplified plan view of a display subassembly;
FIG. 1B is a simplified plan view of an example cover assembly;
FIG. 2 is a simplified cross-sectional view of a portion of an example display assembly;
FIG. 3 is a simplified cross-sectional view of another example display assembly;
FIG. 4 is a plan view of an example pad layout for the display assembly of FIG. 3;
FIG. 5 is a simplified schematic diagram of an example sensor for combined projected capacitive and pressure sensing;
FIG. 6 is a schematic diagram of an example pressure sensing circuit;
FIG. 7 is a cover assembly with an example pad and trace geometry;
FIG. 8 is a cover assembly with another example pad and trace geometry; and
FIG. 9 is a simplified schematic of an example touch event signal flow.

### Description of Exemplary Embodiments

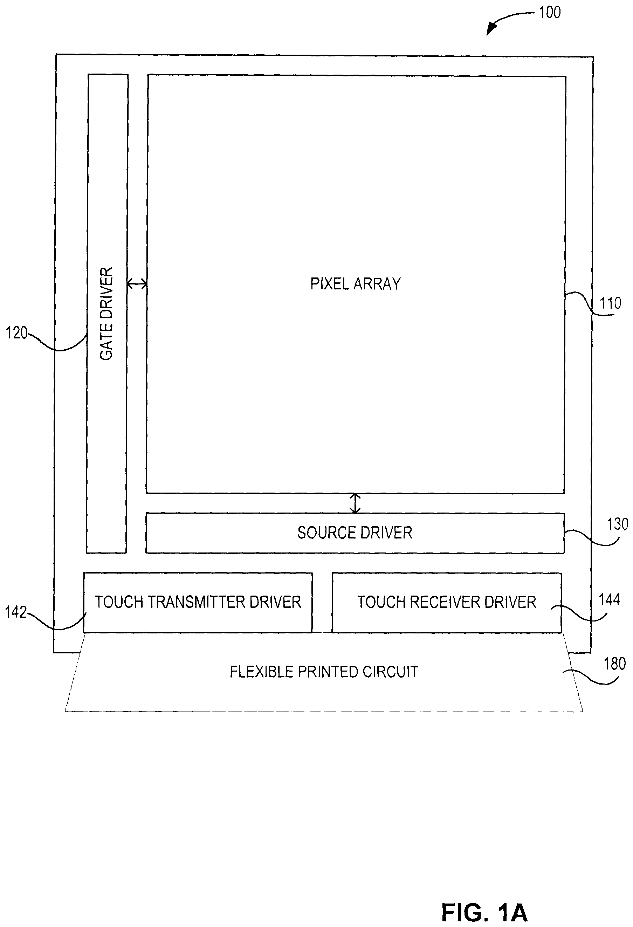

Referring now to FIG. 1A, there is illustrated a simplified plan view of a display subassembly such as that used in a touch sensitive display. Display subassembly 100 includes a pixel array 110, a gate driver 120 and a source driver 130.

Pixel array 10 may include a backplane with an active matrix comprising individually addressable pixels (e.g., liquid crystal display (LCD) or light emitting diode (LED) elements), and a frontplane for optical modulation (e.g., color filters, polarizers, etc.). The backplane may include a plurality of layers, formed of various materials such as glass, polyester and paper.

Each addressable pixel may comprise one or more transistors and, in particular, a thin-film transistor (TFT), for controlling the operation of the pixel. In some embodiments, each pixel may consist of separate sub-pixels, each individually controllable, that are provided with different color filters.

Gate driver 120 and source driver 130 are generally integrated circuits that drive the operation of pixel array 110. Both gate driver 120 and source driver 130 may be integrated into pixel array 110, or provided as separate circuits in a display module using, for example, a flexible printed circuit, chip on glass or chip on flex approach.

In operation, display subassembly 100 forms an image by scanning lines of pixels in pixel array 110. Gate driver 120 provides a signal to open or activate selected pixels (or sub-pixels) in each line of pixel array 110. Source driver 130 then charges each pixel in the line to a preconfigured voltage.

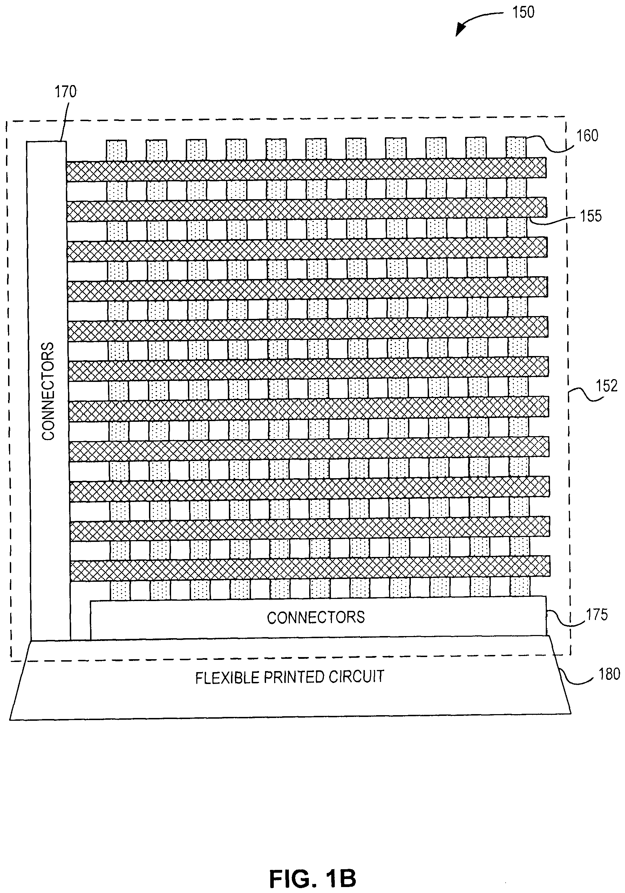

Referring now to FIG. 1B, there is illustrated a simplified plan view of an example cover assembly with integrated touch traces, such as that used in a touch sensitive display.

Cover assembly 150 generally includes multiple layers and may be fabricated by lamination or equivalent methods. In some embodiments, an air gap between layers may be acceptable. An outer layer 152 can be glass or plastic, and is generally the layer that a user may contact with a finger or stylus. A first layer of transmitter touch traces, such as horizontal traces 155, may be provided on the underside of the outer layer. The traces may be formed by depositing a suitable conductor on the glass substrate. For example, indium tin oxide (ITO) or indium zinc oxide (IZO) may be used, as they are substantially optically transparent and can be overlaid on a display pixel array, such as array 110 of FIG. 1A.

An intermediate dielectric or insulating layer (e.g., glass) can be provided, and a second layer of receiver touch traces, such as vertical traces 160, can be provided in similar fashion to form a projected capacitance (pro-cap)sensing grid.

In the illustrated example, each of the horizontal traces 155 is electrically coupled via a plurality of conductors 170 and a flexible printed circuit 180 to a transmitter driver circuit, such as transmitter driver 142 of FIG. 1A, located off-assembly. Similarly, each of the vertical traces 160 is electrically coupled via conductors 175 and flexible printed circuit 180 to a receiver driver circuit, such as receiver driver 144 of FIG. 1A. So as not to obscure the illustration, each of the respective conductive paths is not individually illustrated, however each horizontal and vertical trace may be individually and uniquely coupled to a respective input or output of the respective driver circuit.

Conductors 170 and 175 may be formed of ITO or IZO, or may be formed of opaque materials that exhibit lower resistance, thus allowing for more compact arrangement (e.g., at the periphery of a display).

In operation, transmitter driver 142 applies a voltage to the transmitter traces 160 to create an electrostatic field. In the absence of an external stimulus (e.g., finger or stylus), the electrostatic field has a regular pattern across the grid. Each intersection of a transmitter and receiver trace forms a capacitor, which has a corresponding capacitance that can be measured by a receiver circuit.

When a conductive object contacts the panel, the electrostatic field becomes locally distorted. This distortion causes a change in capacitance (e.g., reduction in mutual capacitance) at an intersection of the transmitter and receiver traces. This change in capacitance can be determined by measuring a voltage on each of the receiver traces 155, to identify the location of a touch event on the grid.

For a typical screen of between 4 and 5 diagonal inches, there are between 10 to 16 transmitter traces 160, and 10 to 16 receiver traces 155, resulting in between 100 to 256 distinct touch locations. Traces are typically between 4 to 6 mm in width, to capture a typical finger touch.

In the illustrated example, the image and touch driver circuits are shown as being integrated on the display panel, however in other embodiments, one or more driver circuits may be provided on a separate assembly, and connected via a flexible printed circuit or other suitable connector.

Provision of touch traces 155 and 160 in the cover assembly facilitates larger signal swings, which increase signal-to-noise ratio, due to the proximity of the finger or stylus to the traces.

In addition, by providing only touch traces on the cover assembly, the ease of repair or replacement is increased, while minimizing cost of repair, since the driving circuits are located on another module.

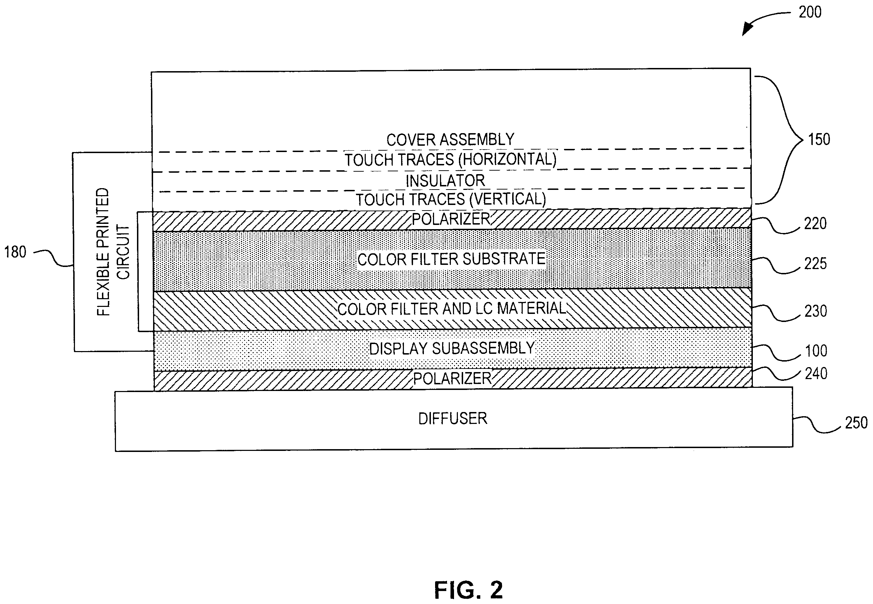

Referring now to FIG. 2, there is illustrated a simplified cross-sectional view of a portion of an example display assembly 200. Display assembly includes a display subassembly 100 of FIG. 1A and a cover assembly 150 of FIG. 1B, along with a flexible printed circuit 180 connecting touch traces to respective driver circuits.

In particular, display assembly 200 has a diffuser 250 that serves as a base layer (e.g., bottom layer or substrate). Diffuser 250 may be a light guide plate (LGP), a brightness enhancing film (BEF) or other suitable diffusing element that serves to diffuse light from, for example, an LED backlight that produces broad spectrum (e.g., white) light.

A polarizer 240 is stacked atop diffuser 250 to polarize light from diffuser 250 and direct it through display subassembly 100. Display subassembly 100 is a TFT layer that includes integrated circuits for controlling each pixel or sub-pixel element in the display assembly 200.

A color filter and liquid crystal layer 230 is stacked atop display subassembly 100. Layer 230 includes liquid crystal elements that respond to control outputs from display subassembly 100 to become selectively opaque or partially opaque. Color filter elements are used to admit only selected wavelengths to cause the pixels or sub-pixels to appear to provide only light of the desired color (e.g., red, green, blue).

A color filter substrate layer 225 is stacked atop layer 230. Color filter substrate layer 225 may be a glass substrate, for example, upon which the color filter portion of layer 230 is adhered or affixed. Generally, the liquid crystal portion of layer 230 is below the color filter portion. A further polarizer 220 may be provided to ensure that stray light does not escape.

A cover assembly 150 as described herein may be stacked atop the polarizer 220. As described, the horizontal and vertical touch traces of the cover assembly 150 may be coupled to respective driver circuits in the display subassembly 100.

Each of the layers of display assembly 200 may be fixed to the other, for example by lamination using a resin or other optically clear adhesive (OCA), portions of the assembly may also be sealed together during fabrication.

Current conventional touch screen displays generally employ pro-cap technology such as that described in FIGS. 1A, 1B and 2. However, currently there is no practical pro-cap technology that incorporates pressure sensing capability. In addition, current methods of pro-cap device construction and driving result in noisy signals that may result in degraded touch performance.

The described embodiments generally provide integrated touch displays with combined pressure and projected capacitance touch capabilities, and methods of fabricating the same. The described embodiments are generally built in a hybrid construction that results in low noise, low latency, low power and low cost. At least some embodiments provide a "one glass solution" (OGS) or "on-cell" construction, on a variety of substrate types (e.g., glass, film, or laminates thereof).

In general, the described embodiments combine all the conventional attributes of pro-cap technology with the additional capability of sensing force or pressure applied to a planar surface, where both the magnitude and location of the force are measured. In addition, the described embodiments may facilitate increased signal-to-noise ratio in the detection of pro-cap touch events and force, while also allowing for reduced latency effects.

The described embodiments are suitable for use in touch panels, including high resolution touch panels such as those found in mobile computing devices (e.g., smartphones, tablets), personal computers, industrial devices and the like.

Pressure sensing can be implemented in capacitive touch sensing devices by incorporating a layer of pressure sensing material in the display stack. This pressure sensing material may be a material that exhibits a piezoelectric or quantum tunneling effect. That is, the pressure sensing material exhibits a change in one or more electrical property (e.g., voltage) corresponding to an applied force or pressure that deforms the material. For example, an applied force may induce a voltage across a piezoelectric material, which results in a current flowing between two terminals connected to the material.

In the case of piezoelectric materials, this change in electrical property may be measured across a portion of the material using two leads or terminals.

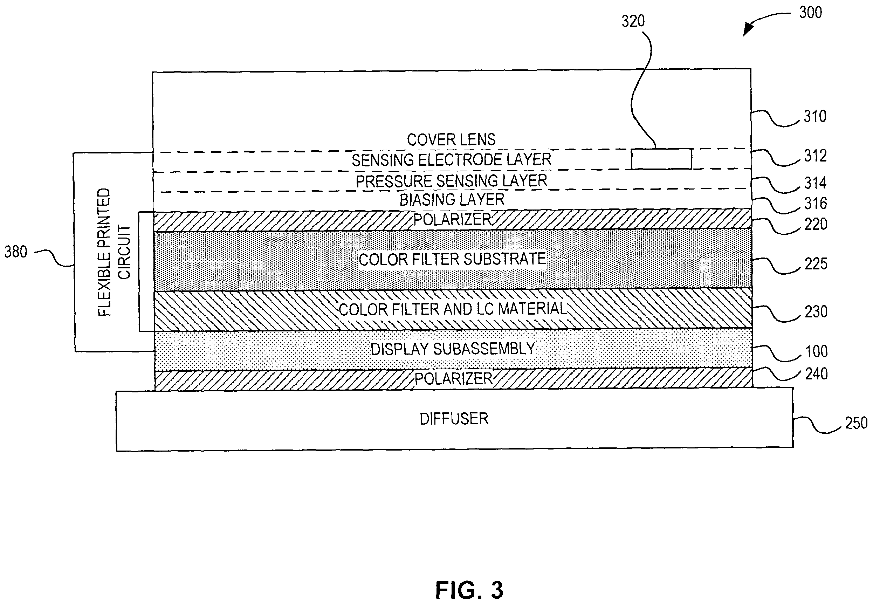

Referring now to FIG. 3, there is illustrated a simplified cross-sectional view of a portion of an example display assembly 300, which incorporates a pressure sensing layer. Display assembly 300 contains layers generally analogous to those of display assembly 200 of FIG. 2, which are labeled with like reference numerals.

In contrast to display assembly 200, display assembly 300 comprises a cover lens 310, a sensing electrode layer 312, a pressure sensing layer 314 and a biasing layer 316. Flexible printed circuit 380 is operatively connected to each of layers 312, 314 and 316, as well as display subassembly 100.

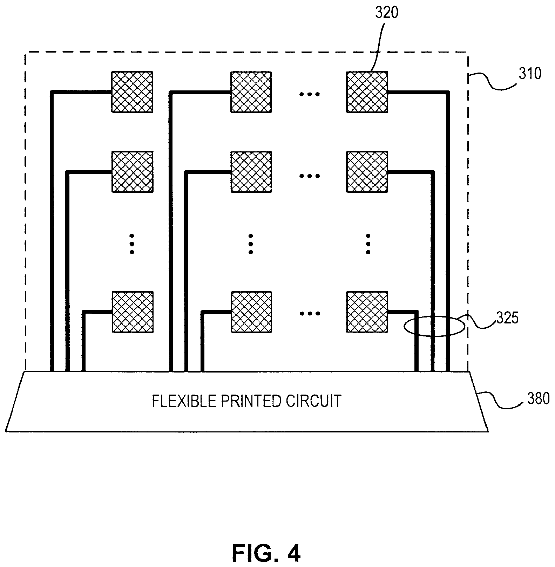

Sensing electrode layer 312 has a plurality of discrete pads 320 deposited, patterned, printed or laminated on cover lens 310. Only one sensing pad 320 is illustrated in FIG. 3, so as not to obscure the illustration. Each of the discrete pads may be formed of ITO, IZO or another suitable optically transparent conductor. Further detail regarding the layout of layer 312 is provided with reference to FIG. 4.

Pressure sensing layer 314 is formed of a pressure sensing material, such as a piezoelectric material. Preferably, the pressure sensing material also acts as a dielectric or insulating layer between sensing electrode layer 312 and biasing layer 316.

In some embodiments, biasing layer 316 may act as a single large driving electrode, which works in conjunction with each of the pads 320 in sensing electrode layer 312 to bias the pressure sensing material to facilitate pressure or force detection. Accordingly, when a force or pressure is applied to a portion of the assembly, one or more pads 320 in the vicinity of the applied force will register a change in voltage or current that will not be registered by the other pads 320 outside the vicinity of the applied force.

Biasing layer 316 may be formed of an optically transparent conductor such as ITO or IZO. In some embodiments, the biasing layer 316 may be a substantially uniform "blanket" layer (i.e., not patterned).

In some embodiments, the pad and trace layer may be deposited on another layer of the display stack (e.g., color filter substrate 225), in which case pressure sensing layer 314 and biasing layer 316 may also be rearranged accordingly.

Referring now to FIG. 4, there is illustrated a plan view of one example pad layout for the display assembly 300 of FIG. 3.

A plurality of pads 320 are arranged in a grid fashion. Although only nine pads are shown, it will be understood that a larger number of pads may be used. The number of individual pads can be selected to provide high resolution spatial detection, for example at the sub-millimeter level.

Each pad 320 has a corresponding conductive trace 325, which is operatively connected to flexible printed circuit 380, which connects to an external driver provided, for example on display subassembly 100. This allows the pads and traces to be implemented with existing cover lens or color filter manufacturing workflows.

The traces 325 may be formed of an optically transparent conductor such as ITO or IZO. Traces 325 may be routed in a regularized or repeating pattern, to facilitate placement of the pads 320 in a desired array pattern. In some cases, traces at the periphery of the display may be formed of an optically opaque conductor that exhibits lower resistance. As the traces do not switch at high frequency and need not switch simultaneously in pro-cap sensing, and further because the traces - being thin relative to the pads - occupy considerably less area than the pads, the effect of noise from the conductive traces is negligible.

The use of discrete pads 320 with a biasing layer 316 enables two forms of projected capacitive touch detection: mutual capacitance with two ITO layers; and self-capacitance with only the top patterned ITO layer.

In contrast to conventional pro-cap devices, which drive transmitter and receiver traces sequentially, monitoring of each of the pads 320 can be simultaneous, meaning there is no requirement for separate transmit and receive acts. Preferably, touch event detection can be synchronized with display programming to minimize or avoid signal interference from switching display pixels. Moreover, pads can be sensed multiple times within a display frame period to improve detection signal-to-noise ratio. This is contrary to conventional touch panel displays, where touch event detection is typically not synchronized to display functions.

In some embodiments, pressure sensing may be triggered in response to a capacitive touch detection, allowing for similar power consumption as with conventional capacitive touch sensing devices.

In some alternate embodiments, TFT amplification circuits may be printed or provided within each pad 320, allowing for in situ amplification rather than amplification in display subassembly 100. This approach may involve TFT processing of the cover lens or color filter, for example, but can significantly improve signal-to-noise ratio, as the detected signal charge can be amplified without any signal deterioration resulting from RC propagation along conductive traces 325.

TFTs may be more opaque than ITO traces or pads, and thus may be aligned to the display's black matrix (BM) to minimize the impact on light transmittance. The BM is typically located on the color filter glass and may be marked with alignment marks, which can be used to align TFT amplification circuits to minimize visual artifacts.

In still further alternate embodiments, TFT amplification circuits may be printed or provided along a periphery of the cover lens or color filter, which typically is obscured by an opaque bezel, thus reducing or eliminating the requirement for alignment with the display BM. Short conductive traces may be provided between each pad 320 and the amplification circuits. This approach represents a reduction in signal-to-noise ratio (SNR) relative to in situ amplification, while still providing a modest gain in SNR relative to off-layer amplification.

Although TFT has been used as an example of a technology suitable for on-glass amplification circuits, other technologies such as amorphous silicon (a-Si), low temperature polysilicon (LTPS), metal oxide TFT (IGZO, MOx), organic TFTs, and the like may also be used.

In some embodiments, pads 320 and conductive traces 325 can be leveraged to perform both conventional pro-cap sensing of touch events and pressure sensing.

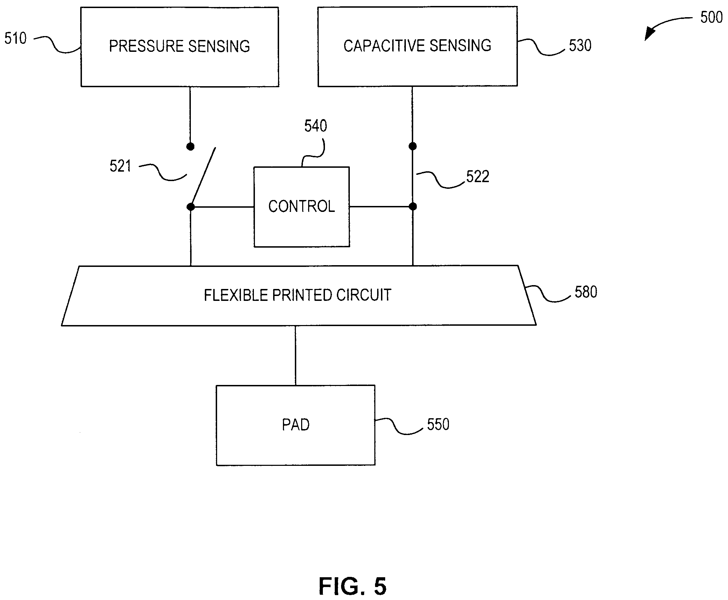

Referring now to FIG. 5, there is illustrated a simplified schematic diagram of an example approach for combined pro-cap and pressure sensing.

A pad 550, such as a pad 320, may be connected (e.g., via a conductive trace 325 and a flexible printed circuit 580), to a pressure sensing circuit 510 and a capacitive sensing circuit 530. Although only one pad and one of each type of sensing circuit is illustrated in FIG. 5, in practice, each individual pad 320 will have a corresponding pressure sensing circuit 510 and a corresponding capacitive sensing circuit 530, allowing all pads to be monitored simultaneously.

A control circuit 540 may selectively enable and disable switches 521 and 522, such that only one of pressure sensing circuit 510 and capacitive sensing circuit 530 is operatively coupled to pad 550 at any one time. In some embodiments, a single control circuit 540 may regulate a plurality of switches for a plurality of pads 550.

Control circuit 540 may synchronize the readout and sensing of touch events to the display frame blanking period, for example, to further enhance SNR.

Capacitive sensing circuit 530 is generally a conventional pro-cap detection and amplification circuit.

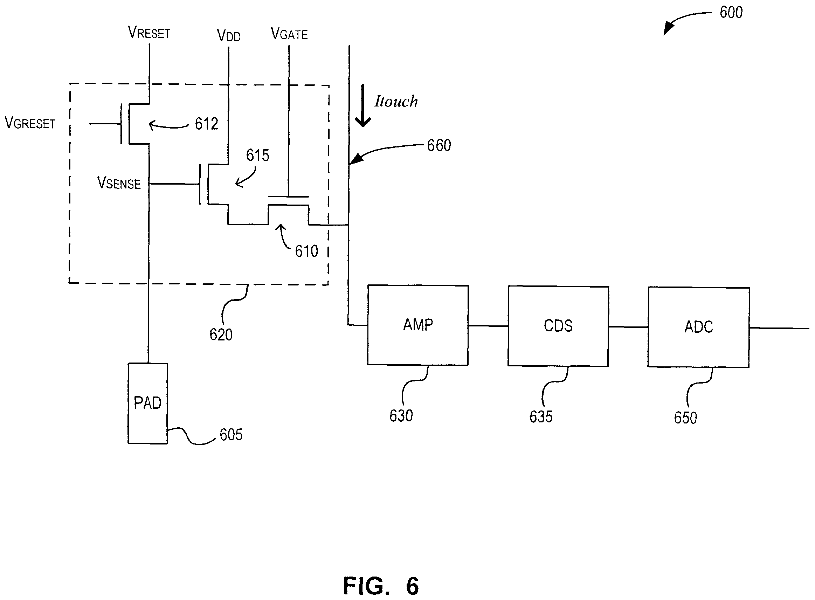

Referring now to FIG. 6, there is illustrated a schematic diagram of an example pressure sensing circuit 600, such as may be used for pressure sensing circuit 510.

Pressure sensing circuit 600 is operatively coupled to a pad 605, and has a reset transistor 612, an integrating transistor 615 and an addressing transistor 610. Each transistor 612, 615 and 610 may be a PMOS or NMOS transistor, for example, depending on the specific circuit configuration.

In operation, an output of pad 605 is connected to a gate of transistor 615, which serves as an integrator. In the example shown, a source of transistor 615 is connected to a bulk supply voltage, causing a drain terminal of transistor 615 to integrate the input to the gate of transistor 615. This integrated output can be coupled to a detection line 660 when an addressing transistor 610 is switched on.

The integrated output can be provided to a column amplifier 630, correlated double sampler 635, and digitized using an analog to digital convertor (ADC) 650.

Correlated double sampler 635 may be used to improve signal accuracy and signal-to-noise ratio. Generally, correlated double sampling is a technique used when measuring sensor outputs, which allows an undesired offset to be removed from a measured value (e.g., voltage, current). To perform correlated double sampling, the output of a sensor may be measured twice: once in a known condition and again in an unknown condition. The value measured during the known condition can be subtracted from the value measured during the unknown condition.

Correlated double sampling is used, for example, in switched capacitor op-amps to improve the gain of a charge-sharing amplifier, while adding an extra phase.

In the described embodiments, correlated double sampling may be performed by measuring the output of a pad after a reset is performed (e.g., the known condition) and subtracting this output from the output at the end of an integration period (e.g., the unknown condition). The reset may be performed, for example, by triggering reset transistor 612.

In some embodiments, the correlated double sampler 635 may be omitted.

Pressure sensing circuit 600 does not require that a pad provide an output voltage concurrently with the detection and amplification. Accordingly, a user's touch may occur separately from the detection event.

Reset transistor 612 can be activated to reset the output pad 605 to a default voltage (e.g., Vreset). This reset pulse may also act to erase any material memory effect that may exist in the pressure sensing element, which could affect the measurement calibration.

In some embodiments, an alternate geometry for the pads and traces may be used.

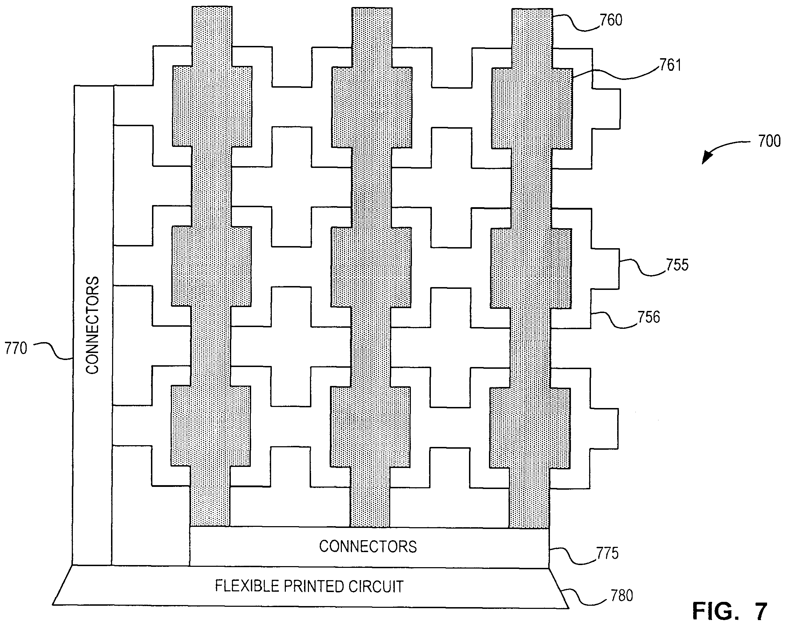

Referring now to FIG. 7, there is illustrated an example cover assembly with example pad and trace geometry, which may be used for both pro-cap and pressure sensing as described herein.

Assembly 700 is generally analogous to cover assembly 150, however each vertical trace 760 may have one or more integrated sensing pads 761, and is connected to a flexible printed circuit 780 via connectors 775.

Similarly, each horizontal trace 755 may have one or more integrated driving pads 756, and is connected to flexible printed circuit 780 via connectors 770.

The use of enlarged, integrated pads both for driving and sensing can improve touch sensitivity with little or no change in the capacitance induced by an intermediate pressure sensing layer.

In general, it is desirable to increase the change in capacitance between the driving and sensing electrodes (or layers) that occurs in response to a touch. This change in capacitance can be increased by maximizing fringing fields. Electrode shapes can be selected to maximize fringing fields. In some cases, electrode shapes may result in a lower absolute capacitance, but a larger change in capacitance relative to some baseline shape.

Accordingly, the shapes each integrated sensing pad and each integrated driving pad may be selected to increase and maximize the fringe capacitance (fringing field) between the driving and sensing electrodes (or between the sensing electrode and biasing layer).

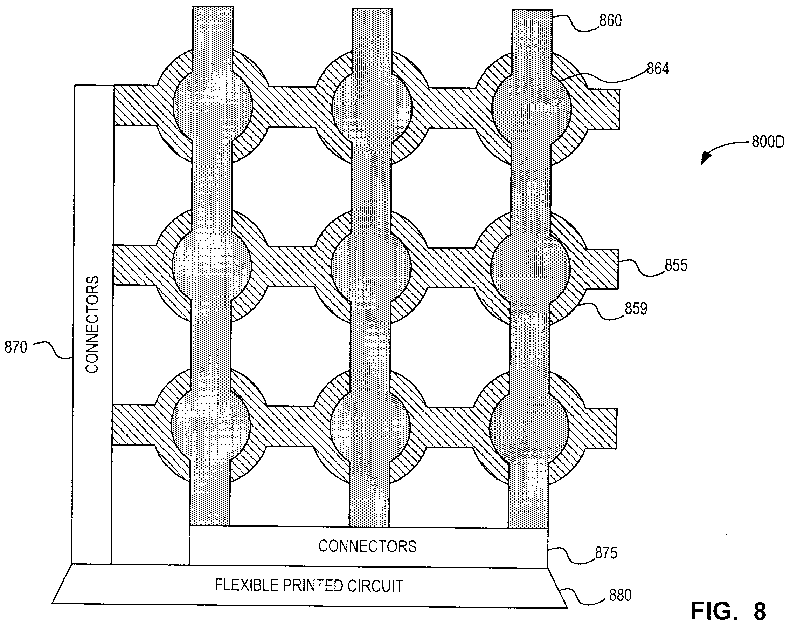

Referring now to FIG. 8, there is illustrated another cover assembly with example pad and trace geometry. The modified pad geometries may serve to increase the number of fringing fields, improving capacitive touch detection.

Cover assembly 800 is generally analogous to cover assembly 700. A plurality of horizontal traces 855 each have one or more integrated driving pads 859, and are connected to a flexible printed circuit 880 via connectors 870. A plurality of vertical traces 860 each have one or more integrated sensing pads 864, and are connected to flexible printed circuit 880 via connectors 875. Each driving pad 859 may have a diameter of approximately 5 mm, for example, and each sensing pad sized accordingly.

As shown in FIG. 8, each integrated sensing pad 864 has a rounded shape, as illustrated. Likewise, each integrated driving pad 859 also has a rounded shape. However, various other shapes and configurations for the padsmay also be used. For example, the driving and sensing pads may have polygonal shapes with a number of sides between 3 and 8, for example. In general, those shapes that maximize fringe capacitance between the sensing and driving electrodes may be preferred.

Although the described embodiments have been described primarily with reference to "one-glass solution" display technologies, the described techniques are applicable to many other display assembly structures, including "in-cell", "on-cell", and laminated panel approaches. In general, the described embodiments provide analog pressure sensing combined with conventional digital touch methods, such as projected capacitive sensing. The described embodiments also allow for high signal to noise ratio, enabling accurate, fast and sensitive touch and force sensing, as well as ultra-low power modes that significantly improve battery life and device operation times compared to known touch panel architectures and technologies.

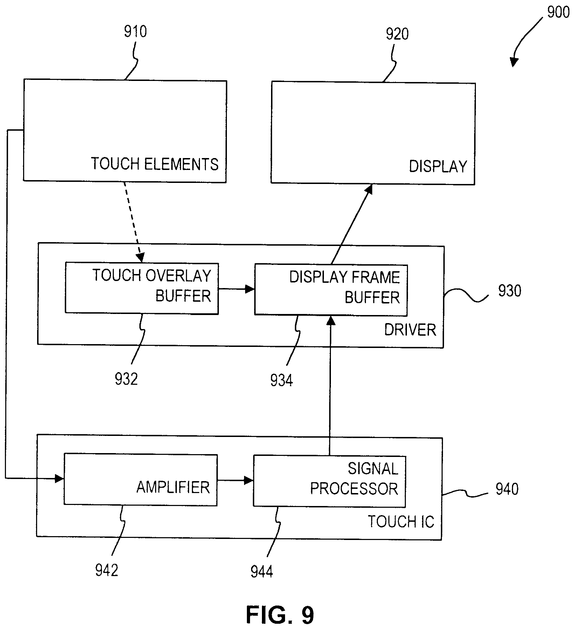

Referring now to FIG. 9, there is illustrated a simplified schematic of an example touch event signal flow 900.

Signal flow 900 occurs between touch sensitive elements of a touch sensor 910, such as pro-cap or pressure sensing elements, a touch sensing integrated circuit 940, a display driver 930 and a display 920.

Touch sensing integrated circuit 940 includes an amplifier 942, as described herein, and a signal processor 944, which performs cleanup and touch detection of the raw amplified signal. For example, signal processor 944 may resolve multiple closely spaced touches as a single touch event, or may determine that a sequence of touch events relates to a "swipe" action.

The processed touch signal may be provided to a processor such as display driver 930, and in particular to a display frame buffer 934. Frame buffer 934 may pre-render and store display data before it is actually displayed by display 920. Pre-rendered data may include "off-screen" data, such as data that is not intended for display in a current view, but which may "scroll" into view in response to a user input, such as a swipe input.

To improve responsiveness to touch events, and to reduce processing latency, raw touch event data may be provided to a touch overlay buffer 932 of the display driver 930 processor. Touch overlay buffer 932 may treat the data from the touch electrode array as a pixelated array of sensors. In effect, touch data may be interpreted as an initial image map, and compressive sensing used to identify the different touch events, including pro-cap and pressure-sensing multi-touch. Pressure levels may be interpreted as levels of grey in the initial image map. This signal processing technique enables fast acquisition and reconstruction of the touch event.

Accordingly, to reduce latency, the raw touch signal from sensor elements 910 is sent directly into the display frame buffer 934 via the touch overlay buffer 932. At the same time, the raw touch signal is provided to the touch sensing integrated circuit 940, where it is amplified by amplifier 942, and processed and analyzed for location and force parameters by signal processor 944.

Signal processor 944 may also perform correlated double sampling, for example, to interpret pressure data, carry out signal clean-up, and to generate a processed image map for the multi-touch event. The processed image map may also contain levels of grey representing pressure levels, such that each pixel in the image map has a respective pressure level mapped as a level of grey.

The processed data, including the processed image map, may be provided to the frame buffer, where it can be used to refine the raw touch signal or initial image map through combining or integration. Subsequently, frame buffer 934 determines which information should be rendered and pushed to display 920.

By using the raw, unprocessed touch event data, frame buffer 934 can begin pre-rendering display content that is expected to be needed for a display frame based on the touch event (e.g., swipe a certain amount). Once the fully processed touch event data is received, the pre-rendered data can be confirmed and pushed to display 920, or may be adjusted with incremental cost to render some additional data.

Although described herein as being performed by signal processor 944, some or all of the described signal procession actions could also be performed by other elements, including a host processor (not shown), or within display driver 930.

It will be appreciated that numerous specific details are set forth in order to provide a thorough understanding of the exemplary embodiments described herein. However, it will be understood by those of ordinary skill in the art that the embodiments described herein may be practiced without these specific details. In other instances, well-known methods, procedures and components have not been described in detail so as not to obscure the embodiments described herein.

## Claims

1. A projected capacitance touchscreen device comprising a pressure sensing assembly, the pressure sensing assembly (300) comprising:
a biasing layer (316) comprising an unpatterned layer;
a sensing electrode layer (312); a piezoelectric material layer (314) provided between the biasing layer and the sensing electrode layer, wherein the piezoelectric material layer acts as a dielectric; **characterized by** further comprising:
a detection line (660);
an integrator (615) having an integrator input coupled to the sensing electrode layer (312) and an integrator output for providing an integrated output;
a first switch (612) configured, in response to receiving a reset input (V_{GRESET}), to provide a reset voltage (V_{RESET}) to the sensing electrode layer and to reset the integrator output to a known condition; and
a second switch (610) having a switch input coupled to the integrator output and a switch output coupled to the detection line, such that the integrated output can be coupled to the detection line when the second switch is switched on, and such that the sensing electrode layer is not required to provide an output voltage concurrently with the second switch being in an on state.

2. The device of claim 1, wherein the biasing layer (316) comprises a substantially uniform layer.

3. The device of claims 1 for 2, wherein the biasing layer (316) is formed of an optically transparent conductive material.

4. The device of any one of claims 1 to 3, wherein the sensing electrode layer (312) comprises a plurality of conductive traces (325), and wherein each trace comprises one or more sensing pads (320, 550, 605).

5. The device of claim 4, wherein the one or more sensing pads (320, 550, 605) are shaped to maximize fringing fields and a change in capacitance between the sensing electrode layer (312) and the biasing layer (316) in response to stimulus.

6. The device of claim 4 or claim 5, wherein the one or more sensing pads (320, 550, 605) have a polygonal shape.

7. The device of claim 4, wherein each conductive trace of the sensing electrode layer (312) terminates in a respective one of the one or more sensing pads (320, 550, 605), or wherein each conductive trace (325) of the sensing electrode layer comprises a plurality of sensing pads (320, 550, 605).

8. The device of any one of claims 4 to 7, wherein the one or more sensing pads (320, 550, 605) are formed of an optically transparent conductive material.

9. The device of claim 7, wherein the conductive trace (325) further comprises an external portion at a periphery of the device, wherein the external portion is formed of an optically opaque conductive material.

10. The device of any one of claims 4 to 9, further comprising a detection circuit operatively connected to the plurality of conductive traces (325) of the sensing electrode layer (312).

11. The device of claim 10, wherein the detection circuit further comprises:
a plurality of pressure sensing circuits (510, 600); and
a plurality of capacitance sensing circuits (530); wherein each conductive trace (325) of the sensing layer (312) is connected to a corresponding pressure sensing circuit (510, 600) and a corresponding capacitive sensing circuit (530), and wherein the detection circuit is configured to monitor each conductive trace (325) of the sensing layer simultaneously.

12. The device of claims 10 or 11, wherein the detection circuit is selectively operable in a first mode and a second mode, wherein in the first mode the detection circuit is configured to detect a change in capacitance at one or more of the conductive traces (325) of the sensing layer (312), and wherein in the second mode the detection circuit is configured to detect a change in electric current at one or more of the conductive traces of the sensing layer.

13. The device of any one of claims 4 to 12, further comprising a processor, wherein the processor is configured to interpret pressure data from the one or more sensing pads as an image map, optionally wherein the pressure data comprises a plurality of pressure levels, and wherein each pixel in the image map has a respective pressure level mapped as a level of grey.

14. The device of claim 13, wherein the pressure data is interpreted using correlated double sampling.

15. The device of claims 13 or 14, wherein the pressure data is interpreted using compressive sensing.

## Patentansprüche

1. Projektionskapazitätsberührungsbildschirm-Vorrichtung, die eine Druckerfassungsanordnung umfasst, wobei die Druckerfassungsanordnung (300) Folgendes umfasst:
eine Vorspannungsschicht (316), die eine unstrukturierte Schicht aufweist;
eine Erfassungselektrodenschicht (312),
eine piezoelektrische Materialschicht (314), die zwischen der Vorspannungsschicht und der Erfassungselektrodenschicht vorgesehen ist, wobei die piezoelektrische Materialschicht als Dielektrikum wirkt;
**dadurch gekennzeichnet, dass** die Vorrichtung ferner Folgendes umfasst:
eine Erkennungsleitung (660);
einen Integrator (615) mit einem Integratoreingang, der mit der Erfassungselektrodenschicht (312) gekoppelt ist, und einem Integratorausgang zur Bereitstellung einer integrierten Ausgabe;
einen ersten Schalter (612), der als Reaktion auf das Empfangen eines Rücksetzeingangssignals (V_{GRESET}) dafür konfiguriert ist, eine Rücksetzspannung (V_{RESET}) an die Erfassungselektrodenschicht anzulegen und den Integratorausgang auf eine bekannte Bedingung zurückzusetzen; und
einen zweiten Schalter (610) mit einem Schalteingang, der mit dem Integratorausgang gekoppelt ist, und einem Schalterausgang, der mit der Erkennungsleitung gekoppelt ist, so dass die integrierte Ausgabe mit der Erkennungsleitung gekoppelt werden kann, wenn der zweite Schalter eingeschaltet ist, und die Erfassungselektrodenschicht nicht gleichzeitig eine Ausgangsspannung bereitstellen muss, wenn sich der zweite Schalter in einem Ein-Zustand befindet.

2. Vorrichtung nach Anspruch 1, wobei die Vorspannungsschicht (316) eine im Wesentlichen gleichförmige Schicht aufweist.

3. Vorrichtung nach Anspruch 1 oder 2, wobei die Vorspannungsschicht (316) aus einem optisch transparenten leitfähigen Material gebildet ist.

4. Vorrichtung nach einem der Ansprüche 1 bis 3, wobei die Erfassungselektrodenschicht (312) eine Vielzahl von Leiterbahnen (325) umfasst und wobei jede Leiterbahn ein oder mehrere Erfassungsfelder (320, 550, 605) umfasst.

5. Vorrichtung nach Anspruch 4, wobei das eine oder die mehreren Erfassungsfelder (320, 550, 605) so geformt sind, dass sie die Streufelder und eine Kapazitätsänderung zwischen der Erfassungselektrodenschicht (312) und der Vorspannungsschicht (316) als Reaktion auf den Stimulus maximieren.

6. Vorrichtung nach Anspruch 4 oder Anspruch 5, wobei das eine oder die mehreren Erfassungsfelder (320, 550, 605) eine polygonale Form aufweisen.

7. Vorrichtung nach Anspruch 4, wobei jede Leiterbahn der Erfassungselektrodenschicht (312) in einem jeweiligen der einen oder mehreren Erfassungsfelder (320, 550, 605) endet oder wobei jede Leiterbahn (325) der Erfassungselektrodenschicht eine Vielzahl von Erfassungsfeldern (320, 550, 605) umfasst.

8. Vorrichtung nach einem der Ansprüche 4 bis 7, wobei das eine oder die mehreren Erfassungsfelder (320, 550, 605) aus einem optisch transparenten leitfähigen Material gebildet sind.

9. Vorrichtung nach Anspruch 7, wobei die Leiterbahn (325) ferner einen äußeren Abschnitt an einer Peripherie der Vorrichtung umfasst, wobei der äußere Abschnitt aus einem optisch undurchsichtigen leitfähigen Material gebildet ist.

10. Vorrichtung nach einem der Ansprüche 4 bis 9, die ferner eine Erkennungsschaltung umfasst, die funktionell mit der Vielzahl von Leiterbahnen (325) der Erfassungselektrodenschicht (312) verbunden ist.

11. Vorrichtung nach Anspruch 10, wobei die Erkennungsschaltung ferner Folgendes umfasst:
eine Vielzahl von Druckerfassungsschaltungen (510, 600); und
eine Vielzahl von Kapazitätserfassungsschaltungen (530);
wobei jede Leiterbahn (325) der Erfassungsschicht (312) mit einer entsprechenden Druckerfassungsschaltung (510, 600) und einer entsprechenden Kapazitätserfassungsschaltung (530) verbunden ist, und
wobei die Erkennungsschaltung so konfiguriert ist, dass sie jede Leiterbahn (325) der Erfassungsschicht gleichzeitig überwacht.

12. Vorrichtung nach Anspruch 10 oder 11, wobei die Erkennungsschaltung selektiv in einem ersten Modus und einem zweiten Modus arbeiten kann, wobei die Erkennungsschaltung im ersten Modus dafür konfiguriert ist, eine Kapazitätsänderung an einer oder mehreren der Leiterbahnen (325) der Erfassungsschicht (312) zu erfassen
und wobei die Erkennungsschaltung im zweiten Modus dafür konfiguriert ist, eine Änderung des elektrischen Stroms an einer oder mehreren der Leiterbahnen der Erfassungsschicht zu erfassen.

13. Vorrichtung nach einem der Ansprüche 4 bis 12, die ferner einen Prozessor umfasst, wobei der Prozessor dafür konfiguriert ist, Druckdaten von dem einen oder den mehreren Erfassungsfeldern als Bildkarte zu interpretieren, optional wobei die Druckdaten eine Vielzahl von Druckniveaus umfassen und wobei jedes Pixel in der Bildkarte ein jeweiliges Druckniveau aufweist, das als Graustufenwert abgebildet ist.

14. Vorrichtung nach Anspruch 13, wobei die Druckdaten unter Verwendung einer korrelierten Doppelabtastung interpretiert werden.

15. Vorrichtung nach Anspruch 13 oder 14, wobei die Druckdaten unter Verwendung von Kompressionserfassung interpretiert werden.

## Revendications

1. Dispositif d'écran tactile à capacité projetée comprenant un ensemble de détection de pression, l'ensemble de détection de pression (300) comprenant :
une couche de polarisation (316) comprenant une couche non structurée ;
une couche d'électrode de détection (312) ;
une couche de matériau piézoélectrique (314) située entre la couche de polarisation et la couche d'électrode de détection, la couche de matériau piézoélectrique agissant comme un diélectrique ;
le dispositif étant **caractérisé en ce qu'**il comprend en outre :
une ligne de détection (660) ;
un intégrateur (615) comportant une entrée d'intégrateur couplée à la couche d'électrode de détection (312) et une sortie d'intégrateur permettant de fournir une sortie intégrée ;
un premier interrupteur (612) conçu, en réponse à la réception d'une entrée de réinitialisation (V_{GRESET}), pour fournir une tension de réinitialisation (V_{RESET}) à la couche d'électrode de détection et pour réinitialiser la sortie d'intégrateur dans un état connu ; et
un second interrupteur (610) comportant une entrée d'interrupteur couplée à la sortie d'intégrateur et une sortie d'interrupteur couplée à la ligne de détection, de sorte que la sortie intégrée puisse être couplée à la ligne de détection quand le second interrupteur est fermé, et de sorte que la couche d'électrode de détection ne soit pas tenue de fournir simultanément une tension de sortie quand le second interrupteur est à l'état fermé.

2. Dispositif selon la revendication 1, dans lequel la couche de polarisation (316) consiste en une couche sensiblement uniforme.

3. Dispositif selon la revendication 1 ou 2, dans lequel la couche de polarisation (316) est constituée d'un matériau conducteur optiquement transparent.

4. Dispositif selon l'une quelconque des revendications 1 à 3, dans lequel la couche d'électrode de détection (312) comprend une pluralité de traces conductrices (325), chaque trace comprenant une ou plusieurs pastilles de détection (320, 550, 605).

5. Dispositif selon la revendication 4, dans lequel la ou les pastilles de détection (320, 550, 605) présentent une forme permettant de maximiser les champs de franges de distorsion et une variation de la capacité entre la couche d'électrode de détection (312) et la couche de polarisation (316) en réponse à une stimulation.

6. Dispositif selon la revendication 4 ou 5, dans lequel la ou les pastilles de détection (320, 550, 605) ont une forme polygonale.

7. Dispositif selon la revendication 4, dans lequel chaque trace conductrice de la couche d'électrode de détection (312) se termine dans une pastille de détection respective de la ou des pastilles de détection (320, 550, 605), ou dans lequel chaque trace conductrice (325) de la couche d'électrode de détection comprend une pluralité de pastilles de détection (320, 550, 605).

8. Dispositif selon l'une quelconque des revendications 4 à 7, dans lequel la ou les pastilles de détection (320, 550, 605) sont constituées d'un matériau conducteur optiquement transparent.

9. Dispositif selon la revendication 7, dans lequel la trace conductrice (325) comprend en outre une partie externe au niveau d'une périphérie du dispositif, la partie externe étant constituée d'un matériau conducteur optiquement opaque.

10. Dispositif selon l'une quelconque des revendications 4 à 9, comprenant en outre un circuit de détection connecté de manière fonctionnelle à la pluralité de traces conductrices (325) de la couche d'électrode de détection (312).

11. Dispositif selon la revendication 10, dans lequel le circuit de détection comprend en outre :
une pluralité de circuits de détection de pression (510, 600) ; et
une pluralité de circuits de détection de capacité (530) ;
chaque trace conductrice (325) de la couche de détection (312) étant connectée à un circuit de détection de pression (510, 600) correspondant et à un circuit de détection de capacité (530) correspondant, et
le circuit de détection étant conçu pour surveiller simultanément chaque trace conductrice (325) de la couche de détection.

12. Dispositif selon la revendication 10 ou 11,
dans lequel le circuit de détection peut fonctionner de manière sélective dans un premier mode et dans un second mode, le circuit de détection étant conçu, dans le premier mode, pour détecter une variation de la capacité au niveau d'une ou plusieurs des traces conductrices (325) de la couche de détection (312), et
le circuit de détection étant conçu, dans le second mode, pour détecter une variation de courant électrique au niveau d'une ou plusieurs des traces conductrices de la couche de détection.

13. Dispositif selon l'une quelconque des revendications 4 à 12, comprenant en outre un processeur, le processeur étant conçu pour interpréter sous la forme d'une carte d'image des données de pression en provenance de la ou des pastilles de détection, les données de pression comprenant éventuellement une pluralité de niveaux de pression, et chaque pixel de la carte d'image ayant un niveau de pression respectif correspondant à un niveau de gris.

14. Dispositif selon la revendication 13, dans lequel les données de pression sont interprétées au moyen d'un échantillonnage à double corrélation.

15. Dispositif selon la revendication 13 ou 14, dans lequel les données de pression sont interprétées au moyen d'une détection de compression.
